Europäisches Patentamt

European Patent Office

Office européen des brevets

(11) Publication number: **0 037 262**
**B1**

(12) **EUROPEAN PATENT SPECIFICATION**

(45) Date of publication of patent specification: **17.09.86**

(51) Int. Cl.⁴: **G 11 C 7/00,** G 11 C 11/24, H 01 L 27/10

(21) Application number: **81301327.3**

(22) Date of filing: **27.03.81**

(54) Semiconductor memory device.

(30) Priority: **31.03.80 JP 41810/80**

(43) Date of publication of application:
**07.10.81 Bulletin 81/40**

(45) Publication of the grant of the patent:
**17.09.86 Bulletin 86/38**

(84) Designated Contracting States:
**DE FR GB**

(56) References cited:
**DE-A-2 739 086**
**US-A-4 028 557**

**PATENTS ABSTRACTS OF JAPAN, vol. 1, no.
103, September 1977, page 3316 E 76**

**PATENTS ABSTRACTS OF JAPAN, vol. 4, no.
82(P-15)(564), 13th June 1980 page 60 P 15**

(73) Proprietor: **FUJITSU LIMITED**
**1015, Kamikodanaka Nakahara-ku
Kawasaki-shi Kanagawa 211 (JP)**

(72) Inventor: **Takemae, Yoshihiro
20-5-9-301 Utsukushigaoka 1-chome
Midori-ku, Yokohama-shi, Kanagawa 227 (JP)**

(74) Representative: **Sunderland, James Harry et al
HASELTINE LAKE & CO Hazlitt House 28
Southampton Buildings Chancery Lane
London WC2A 1AT (GB)**

## Description

The present invention relates to a semiconductor memory device and, more particularly, to an MIS (Metal-Insulator-Semiconductor) dynamic memory device of a one-transistor and one-capacitor type.

In general, an MOS (broadly, MIS) dynamic memory device of one-transistor and one-capacitor type incorporates memory cells, each comprising a transistor and a capacitor. In this case, the transistor serves as a switching gate for charging or discharging the capacitor. In addition, the presence of charges in the capacitor corresponds to the data "0" or "1". For example, the state in which the capacitor is discharged corresponds to the data "0", while the state in which the capacitor is charged corresponds to the data "1".

The above-mentioned transistors has a gate connected to a word line, a drain connected to a bit line and a source connected to an electrode of the capacitor which, in turn, has a counter electrode connected to a power supply, which is usually the ground or another power supply $V_{cc}$. In the stand-by state, the bit line is precharged by the power supply $V_{cc}$.

Therefore, if the data "0" is stored in the memory cell, a charge $Q_1$ stored in the capacitor thereof is

$$Q_1 = 0.$$

Contrary to the above, if the data "1" is stored in the memory cell, a charge $Q_2$ stored in the capacitor thereof is

$$Q_2 = C(V_{cc} - V_{th})$$

where C is the capacitance of the capacitor;

$V_{cc}$ is also a voltage of the power supply $V_{cc}$; and

$V_{th}$ is a threshold voltage of the transistor. Therefore, the difference $\Delta Q$ between the charges $Q_1$ and $Q_2$ is

$$\Delta Q = C(V_{cc} - V_{th})$$

However, in the above-mentioned memory cell in which the counter electrode of the capacitor is connected to the power supply $V_{cc}$ or the ground, in other words, the potential of the counter electrode is definite, the difference $\Delta Q$ is relatively small, which invites an unstable read operation, since the operation of a sense amplifier for amplifying the difference in potential between the bit lines is dependent upon the difference $\Delta Q$.

DE—A—2 739 086 discloses a semiconductor memory device having features as mentioned in the precharacterising part of claim 1.

According to the present invention there is provided a semiconductor memory device comprising:

a plurality of word lines;

a plurality of power supply lines;

a plurality of pairs of bit lines;

a plurality of sense amplifiers, each arranged between the bit lines of one of said pairs of bit lines;

a plurality of memory cells, each comprising a transistor and a capacitor, said transistor having a gate connected to one of said word lines and a drain connected to one of said bit lines, said capacitor having an electrode connected to a source of said transistor and a counter electrode connected to one of said power supply lines; and

a plurality of means, each connected to one of said power supply lines for supplying a signal to the power supply line;

characterised in that

when one of said plurality of word lines is selected, for reading a memory cell the gate of the transistor of which is connected to that one word line, that one of said plurality of means connected to that one of the said plurality of power supply lines which is connected to the counter electrode of the capacitor of the memory cell concerned is selectively operable, during an active memory cycle, at the time of or after the rising of the potential of the selected word line, to supply to the said one power supply line a clock signal which falls and after that rises.

It is a principal object of the present invention to provide a semiconductor memory device with a stable read operation.

The present invention will be more clearly understood from the following description contrasting the present invention with the conventional device and with reference to the accompanying drawings, wherein:

Fig. 1A is a cross-sectional view illustrating a memory cell of a one-transistor and one-capacitor type;

Fig. 1B is an equivalent circuit diagram of the memory cell of Fig. 1A;

Fig. 2 is a block diagram illustrating a conventional semiconductor memory device;

Fig. 3 is a circuit diagram of a part of the device of Fig. 2;

Fig. 4A, 4B and 4C are timing diagrams of the signals appearing in the circuit of Fig. 3;

Fig. 5 is a block diagram illustrating an embodiment of the semiconductor memory device according to the present invention;

Fig. 6 is a circuit diagram of a part of the device of Fig. 5;

Figs. 7A, 7B and 7C are timing diagrams of the signals appearing in the circuit of Fig. 6;

Fig. 8 is a block diagram illustrating another embodiment of the semiconductor memory device according to the present invention;

Fig. 9 is a circuit diagram of a part of the device of Fig. 8; and

Figs. 10A, 10B and 10C are timing diagrams of the signals appearing in the circuit of Fig. 9.

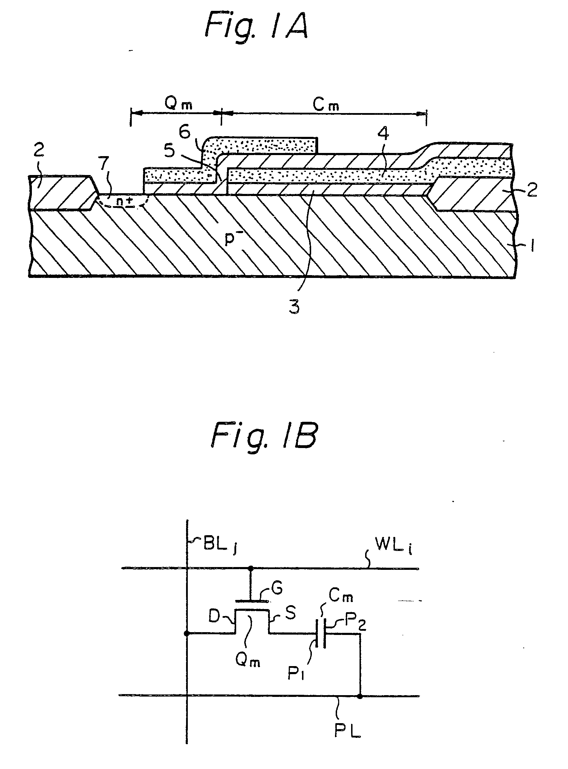

Referring to Fig. 1A, which illustrates a one-transistor and one-capacitor type memory cell, the memory cell is manufactured by using a so-called double-layer polycrystalline silicon technology. In Fig. 1A, 1 is a semiconductor substrate which is, for example, $p^-$-type monocrystalline silicon; 2 is a field layer which is relatively thick and made of, for example, silicon dioxide; 3 and 5 are insulating layers which are relatively thin and made of, for example, silicon dioxide; 4 and 6 are first and second conductive layers, respectively, and made of, for example, polycrystalline silicon; and 7 is an $n^+$-type impurity doped region. In this case, an MOS transistor $Q_m$ comprises a source formed by an inversion layer within the substrate 1 under the insulating layer 3, a drain formed by the impurity doped region 7 and a gate formed by the second conductive layer 6, while a capacitor $C_m$ comprises an electrode formed by the substrate and its counter electrode formed by the first conductive layer 4 with the insulating layer 3 therebetween. Of course, various kinds of memory cells of a one-transistor and one-capacitor type have been developed; however, the memory cell as illustrated in Fig. 1A is a representative one which has an advantage in that in the integration density thereof is high.

Fig. 1B is an equivalent circuit diagram of the memory cell of Fig. 1A. In Fig. 1B, in the transistor $Q_m$, a drain D and a gate G are connected to a bit line $BL_j$ and a word line $WL_i$, respectively, and in addition, a source S is connected to an electrode $P_1$ of the capacitor $C_m$ which, in turn, has a counter electrode $P_2$ connected to a power supply line PL. In general, the power supply line PL is stationary; that is, it is grounded.

The transistor $Q_m$ is used for charging or discharging the capacitor $C_m$. For example, when the potential of the word line $WL_i$ is high (in this case, the transistor $Q_m$ is of an n-channel type), the bit line $BL_j$ is electrically connected to the electrode $P_1$ of the capacitor $C_m$ so that a charge is transferred from the bit line $BJ_j$ to the electrode $P_1$ or vice versa responsive to the potential of the bit line $BL_j$. In this case, the presence of a charge in the electrode $P_1$ of the capacitor $C_m$ corresponds to the data "0" or "1".

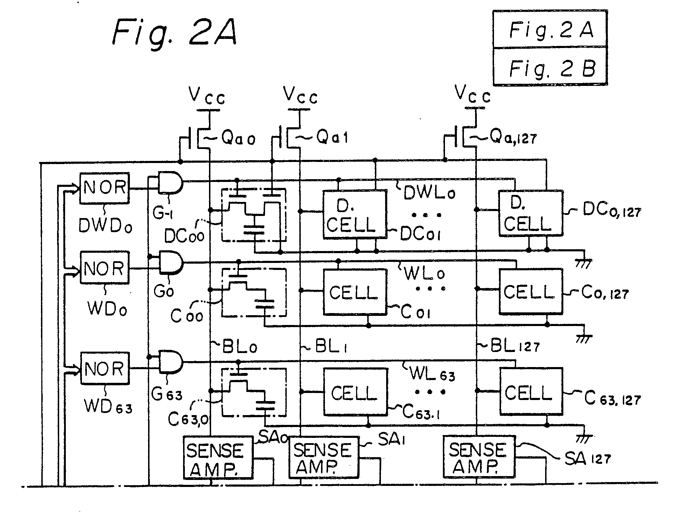

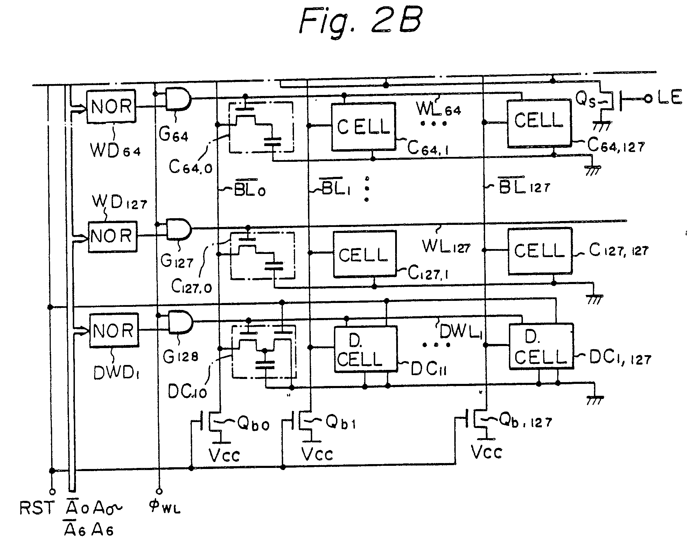

Fig. 2 is a block diagram illustrating a conventional semiconductor memory device incorporating a plurality of the above-mentioned memory cells of a one-transistor and one-capacitor type. In Fig. 2, for example, 16,384 memory cells $C_{00}$, $C_{01}$, ..., $C_{0,127}$; $C_{10}$, $C_{11}$, ..., $C_{1,127}$; ..., $C_{127,127}$ are arranged in 128 rows and 128 columns to form matrixes at intersections of word lines $WL_0$, ..., $WL_{63}$, $WL_{64}$, ..., $WL_{127}$ and bit lines $BL_0$, $\overline{BL_0}$, $BL_1$, $\overline{BL_1}$, ..., $BL_{127}$, $\overline{BL_{127}}$. In this case, each sense amplifier, $SA_0$, $SA_1$, ..., $SA_{127}$, is located between each pair of the bit lines, such as $BL_0$ and $\overline{BL_0}$, with each bit line being connected to the respective side of the sense amplifier.

In addition, dummy memory cells $DC_{00}$, $DC_{01}$, ..., $DC_{0,127}$ are connected to the bit lines $BL_0$, $BL_1$, ..., $BL_{127}$, respectively, while dummy memory cells $DC_{10}$, $DC_{11}$, ..., $DC_{1,127}$ are connected to the bit lines $\overline{BL_0}$, $\overline{BL_1}$, ..., $\overline{BL_{127}}$, respectively. Further, transistors $Q_{a0}$, $Q_{a1}$, ..., $Q_{a,127}$ are connected to the bit lines $BL_0$, $BL_1$, ..., $BL_{127}$, respectively, in order to precharge these bit lines, while, transistors $Q_{b0}$, $Q_{b1}$, ..., $Q_{b,127}$ are connected to the bit lines $\overline{BL_0}$, $\overline{BL_1}$, ..., $\overline{BL_{127}}$, respectively, in order to precharge these bit lines.

In order to select one of the word lines $WL_0$, ..., $WL_{63}$, $WL_{64}$, ..., $WL_{127}$, word decoders $WD_0$, ..., $WD_{63}$, $WD_{64}$, ..., $WD_{127}$ each comprised of an NOR gate are connected to the word lines through gates $G_0$, ..., $G_{63}$, $G_{64}$, ..., $G_{127}$ which are controlled by a clock signal $\phi_{WL}$. In addition, in order to select one of dummy word lines $DWL_0$ and $DWL_1$, dummy word decoders $DWD_0$ and $DWD_1$ each comprised of an NOR gate are connected to the dummy word lines through gates $G_{-1}$ and $G_{128}$ which are also controlled by the clock signal $\phi_{WL}$. In this case, each of the word decoders $WD_0$, ..., $WD_{63}$, $WD_{64}$, ..., $WD_{127}$ receives a combination of seven signals selected from fourteen address signals $\overline{A_0}$, $A_0$, ..., $\overline{A_6}$, $A_6$, while each of the dummy word decoders $DWD_0$ and $DWD_1$ receives a signal, for example, the address signal $A_6$ and $\overline{A_6}$, respectively.

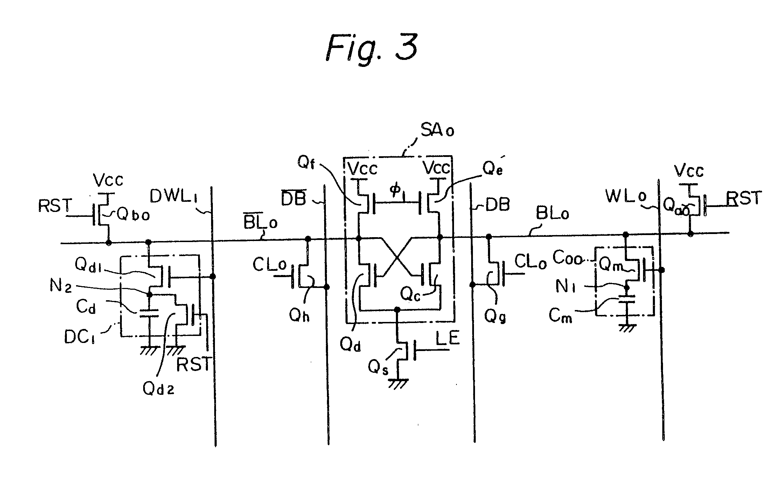

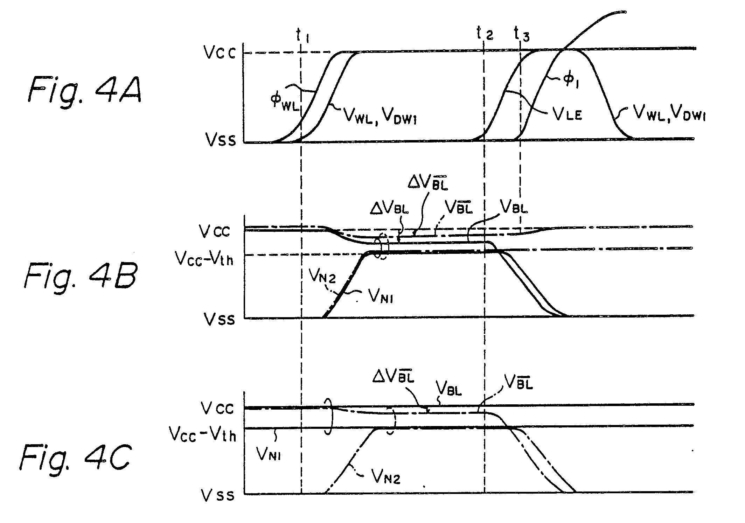

The operation of the device of Fig. 2 will be explained by using Fig. 3 and Figs. 4A, 4B and 4C. Here, Fig. 3 is a circuit diagram of a part of the device of Fig. 2, for explaining the read operation of the memory cell $C_{00}$ and Figs. 4A, 4B and 4C are timing diagrams of the signals appearing in the circuit of Fig. 3. In more detail, Figs. 4B and 4C are used for explaining the read operation for the data "0" and "1", respectively. Note that the $(DC_{10}$ in Fig. 2) capacitance of a capacitor $C_d$ of the dummy memory cells $DC_1$ is about one-half of that of a capacitor $C_m$ of the memory cell $C_{00}$.

In Fig. 3, the sense amplifier $SA_0$ comprises two cross-coupled transistors $Q_c$ and $Q_d$ which constitute a flip-flop, and two transistors $Q_e$ and $Q_f$ for pulling up one of the potentials of the bit lines $BL_0$ and $\overline{BL_0}$. In addition, the bit lines $BL_0$ and $\overline{BL_0}$ are connected to data bus lines DB and $\overline{DB}$, respectively, by transistors $Q_g$ and $Q_h$ controlled by a column selection signal $CL_0$ which are, however, not shown in Fig. 2. In addition, the dummy cell $DC_1$ comprises a transistor $Q_{d1}$ and a capacitor $C_d$ which are similar to the transistor $Q_m$ and the capacitor $C_m$, respectively, of the memory cell $C_{00}$ and in addition, a transistor $Q_{d2}$ for discharging the capacitor $C_d$ in the stand-by state.

In the stand-by state, the transistors $Q_{a0}$ and $Q_{b0}$ are turned on by causing the potential of a reset signal RST to be high, so that the bit lines $BL_0$ and $\overline{BL_0}$ are precharged to the power supply voltage $V_{cc}$ and simultaneously, a transistor $Q_{d2}$ of the dummy memory cell $DC_1$ is also turned on, so that the capacitor $C_d$ is discharged; that is, the potential at a node $N_2$ is the power supply voltage $V_{ss}$ (ground). After that, the potential of the reset signal RST returns to the voltage $V_{ss}$ so that the bit lines $BL_0$ and $\overline{BL_0}$ become in a floating state.

In order to read the data stored in the cell $C_{00}$, the word decoder $WD_0$ (Fig. 2) is triggered and the potential of the clock signal $\phi_{WL}$ rises, so that the potential $V_{WL}$ of the word line $WL_0$ rises at a time $t_1$, as illustrated in Fig. 4A, and accordingly the transistor $Q_m$ conducts. As a result, if the data stored in the cell $C_{00}$ is "0", a current flows from the bit line $BL_0$ into a node $N_1$ of the cell $C_{00}$, so

that the potential $V_{BL}$ of the bit line BL falls from $V_{cc}$ to $\Delta V_{BL}$ and in turn, the potential $V_{N1}$ at the node $N_1$ rises from $V_{ss}$—$V_{th}$, where $V_{th}$ is a threshold voltage of the transistor $Q_m$, as illustrated in Fig. 4B. In this case, the voltage-drop $\Delta V_{BL}$ is

$$\Delta V_{BL} = \frac{C}{C_B} (V_{cc}—V_{th})$$

where $C_B$ and C are capacitances of the bit line BL and the capacitor $C_m$, respectively. On the other hand, simultaneously, the dummy word decoder $DWD_1$ (Fig. 2) is triggered so that the potential $V_{DW1}$ of the dummy word line $DWL_1$ rises, as illustrated in Fig. 4A, and accordingly, a transistor $Q_{d1}$ conducts. As a result, a current flows from the bit line $\overline{BL_0}$ into a node $N_2$ of the dummy memory cell $DC_1$, so that the potential $V_{\overline{BL}}$ of the bit line $\overline{BL_0}$ falls from $V_{cc}$ to $V_{cc}—\Delta V_{\overline{BL}}$ and in turn, the potential $V_{N2}$ at the node $N_2$ rises from $V_{ss}$ to $V_{cc}—V_{th}$, as illustrated in Fig. 4B. In this case, the voltage-drop $\Delta V_{\overline{BL}}$ is selected as to satisfy $\Delta V_{\overline{BL}} = \frac{1}{2}\Delta V_{BL}$.

Contrary to the above, if the data stored in the cell $C_{00}$ is "1", no current flows from the bit line $BL_0$ into the node $N_1$ of the cell $C_{00}$, so that the potential $V_{BL}$ of the bit line BL remains at the same level $V_{cc}$ and the potential $V_{N1}$ at the node $N_1$ also remains at the same level $V_{cc}—V_{th}$. On the other hand, in the dummy memory cell $DC_1$, in the same way as the case where the data "0" is stored, the potential $V_{\overline{BL}}$ of the bit line $\overline{BL_0}$ falls from $V_{cc}$ to $V_{cc}—\Delta V_{\overline{BL}}$ and in turn, the potential $V_{N2}$ at the node $N_2$ rises from $V_{ss}$ to $V_{cc}—V_{th}$, as illustrated in Fig. 4C.

In any case, the difference $\frac{1}{2}\Delta V_{BL}$ in potential between the bit lines $BL_0$ and $\overline{BL_0}$ is generated. Therefore, at a time $t_2$, the potential $V_{LE}$ of a latch enable signal LE rises so as to trigger the sense amplifier $SA_0$. As a result, one of the potentials $V_{BL}$ and $V_{\overline{BL}}$ reaches $V_{cc}$ and the other reaches $V_{ss}$.

Note that, in Fig. 4B, at a time $t_3$, the potential $V_{\overline{BL}}$ of the bit line $\overline{BL_0}$ rises from $V_{cc}—\Delta V_{\overline{BL}}$ to $V_{cc}$ due to the active pull-up effect, since the potential of a signal $\phi_1$ rises so that the transistors $Q_e$ and $Q_f$ become conductive.

Next, by causing the potential of a column selection signal $CL_0$ to be high, the potentials of the bit lines $BL_0$ and $\overline{BL_0}$ are transmitted into an input/output amplifier (not shown) through the data bus lines DB and $\overline{DB}$. After the read operation is completed, the potential $V_{WL}$ of the word line $WL_0$ becomes at the level $V_{ss}$ so that the memory device becomes in the stand-by state. At this time, the data "0" or "1" is stored in the memory cell $C_{00}$.

In the case of the data "0", the charge $Q_1=0$ is charged in the capacitor $C_m$, while, in the case of the data "1", the charge $Q_2=C(V_{cc}—V_{th})$ is charged in the capacitor $C_m$. Therefore, the difference $\Delta Q$ in charges between the data "0" and "1" is $\Delta Q=C(V_{cc}—V_{th})$. In the present inven-

tion, the difference $\Delta Q$ is increased so as to increase the difference in potential between the bit lines $BL_0$ and $\overline{BL_0}$ prior to the operation of the same amplifier $SA_0$, which is helpful in a stable operation of the sense amplifier $SA_0$.

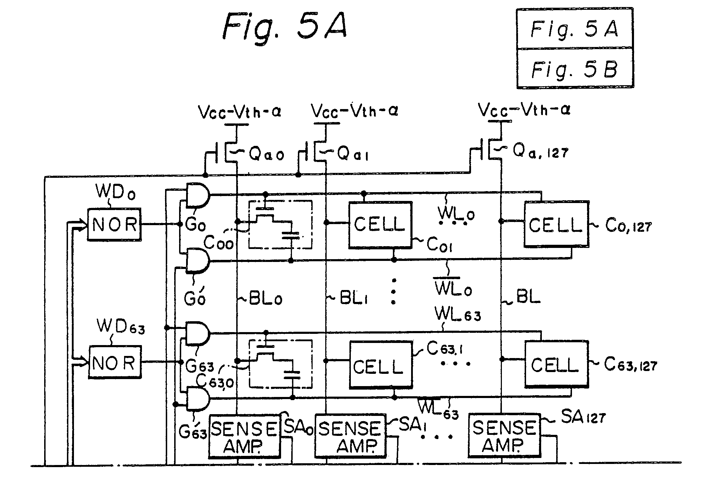

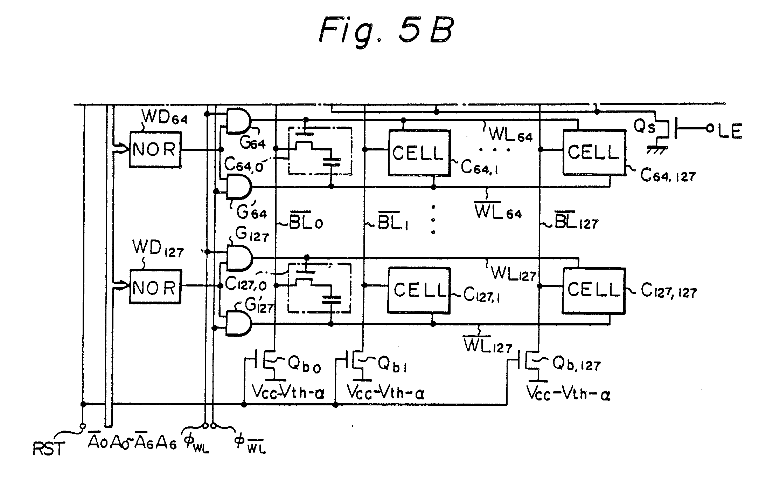

Fig. 5 is a block diagram illustrating an embodiment of the semiconductor memory device according to the present invention. In Fig. 5, the elements which are the same as those in Fig. 2 are denoted by the same references. In Fig. 5, the memory cells $C_{00}, C_{01}, \ldots, C_{0,127}; C_{10}, C_{11}, \ldots, C_{1,127}; \ldots, C_{127,127}$ are connected to power supply lines $\overline{WL_0}, \ldots, \overline{WL_{63}}, \overline{WL_{64}}, \ldots, \overline{WL_{127}}$, not to the power supply $V_{ss}$ (ground). In this case, the potentials of the power supply lines $\overline{WL_0}, \ldots, \overline{WL_{63}}, \overline{WL_{64}}, \ldots, \overline{WL_{127}}$ are changeable. However, the dummy memory cells $DC_{00}, DC_{01}, \ldots, DC_{0,127}$ and $DC_{10}, DC_{11}, \ldots, DC_{1,127}$ of Fig. 3 are not provided. Further, the potential for precharging the bit lines $BL_0$ and $\overline{BL_0}$ is $V_{cc}—V_{th}—\alpha$. Here, $\alpha$ is a voltage necessary for maintaining the conduction of the transistor $Q_m$ when the potential $V_{WL}$ of the word line $WL_0$ is $V_{cc}$.

In the present invention, the difference between the charges stored in the capacitors $C_m$ of the memory cells in correspondence to the data "0" and the data "1" is increased by causing the potentials of the power supply lines $\overline{WL_0}, \ldots, \overline{WL_{63}}, \overline{WL_{64}}, \ldots, \overline{WL_{127}}$ to be low and after that, to be high. The changes of the potentials of the power supply lines $\overline{WL_0}, \ldots, \overline{WL_{63}}, \overline{WL_{64}}, \ldots, \overline{WL_{127}}$ can be effected by a clock signal $\phi_{\overline{WL}}$ through gates $G_0', \ldots, G_{63}', G_{64}', \ldots, G_{127}'$.

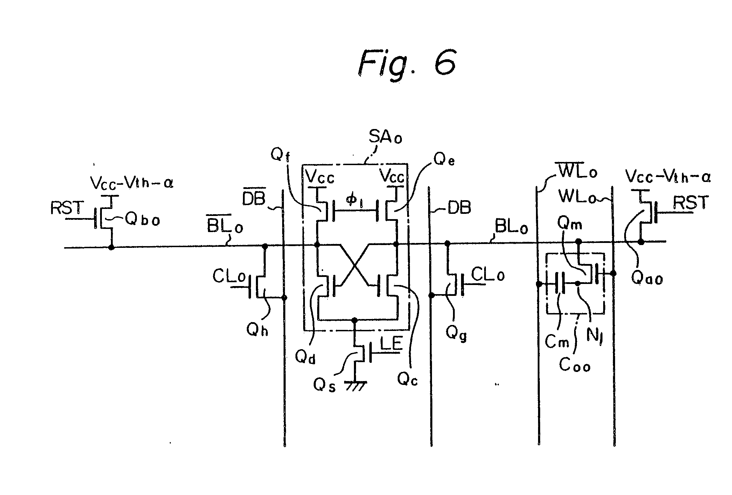

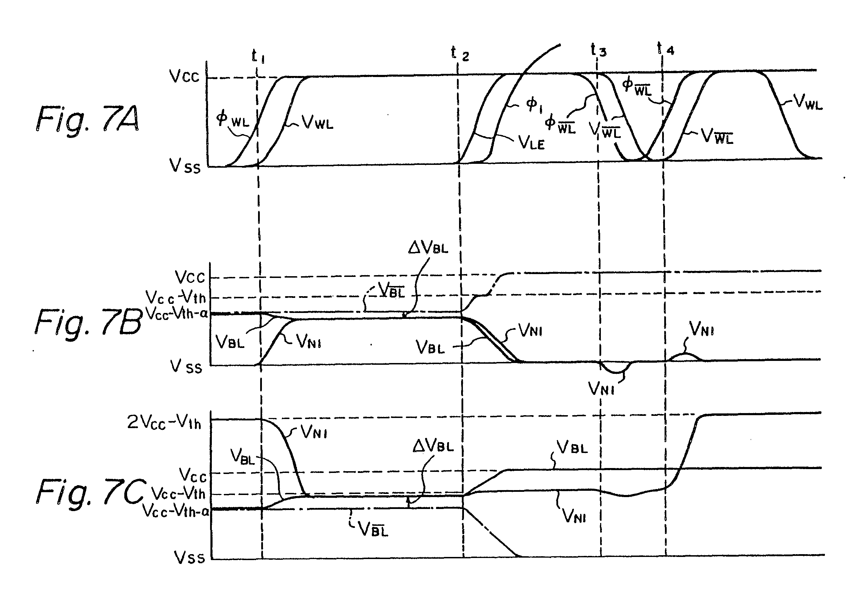

The operation of the device of Fig. 5 will be explained by using Fig. 6 and Figs. 7A, 7B and 7C. Here, Fig. 6 is also a circuit diagram of a part of the device of Fig. 5 and Figs. 7A, 7B and 7C are timing diagrams of the signals appearing in the circuit of Fig. 5. In more detail, Figs. 7B and 7C are used for explaining the read operation for the data "0" and "1", respectively.

In the stand-by state, the transistors $Q_{a0}$ and $Q_{b0}$ are turned on by causing the potential of the reset signal RST to be high, the bit lines $BL_0$ and $\overline{BL_0}$ are precharged to $V_{cc}—V_{th}—\alpha$. After that, the potential of the signal RST returns to the voltage $V_{ss}$ (ground) so that the bit lines $BL_0$ and $\overline{BL_0}$ become in a floating state.

In order to read the data stored in the cell $C_{00}$, the word decoder $WD_0$ (Fig. 5) is triggered and the potential of the clock signal $\phi_{WL}$ rises, so that the potential $V_{WL}$ of the word line $WL_0$ rises at a time $t_1$, as illustrated in Fig. 7A. As a result, the transistor $Q_m$ conducts and accordingly, if the data stored in the cell $C_{00}$ is "0", a current flows from the bit line $BL_0$ into the node $N_1$ of the cell $C_{00}$. Therefore, the potential $V_{BL}$ of the bit line BL falls from $V_{cc}—V_{th}—\alpha$ to $V_{th}—\alpha—\Delta V_{BL}$ and in turn, the potential $V_{N1}$ at the node $N_1$ rises from $V_{ss}$ to

$$V_{cc}—V_{th}—\alpha—\Delta V_{BL},$$

as illustrated in Fig. 7B. In this case, the voltage-drop $\Delta V_{BL}$ is

$$\Delta V_{BL}=\frac{C}{C+C_B}(V_{cc}-V_{th}-a).$$

On the other hand, the potential $V_{\overline{BL}}$ of the bit line $\overline{BL}_0$ remains at the same level, since there is no dummy memory cell connected to the bit line $\overline{BL}_0$.

At a time $t_2$ when the potential $V_{LE}$ of the latch signal LE rises as illustrated in Fig. 7A, the sense amplifier $SA_0$ is triggered so as to amplify the difference $\Delta V_{BL}$ in potential, as illustrated in Fig. 7B. After that, the potential of the signal $\phi_1$ rises as illustrated in Fig. 7A, and the potential $V_{\overline{BL}}$ of the bit line $\overline{BL}_0$ is pulled up to $V_{cc}$. Thus, the read operation for the data "0" is completed.

Next, as illustrated in Fig. 7A, the potential of the signal $\phi_{\overline{WL}}$ falls from $V_{cc}$ to $V_{ss}$ and after that, again, it rises from $V_{ss}$ to $V_{cc}$. Accordingly, at a time $t_3$, the potential $V_{\overline{WL}}$ of the power supply line $\overline{WL}_0$ falls from $V_{cc}$ to $V_{ss}$ and, at a time $t_4$, it rises from $V_{ss}$ to $V_{cc}$. During the falling of the potential $V_{\overline{WL}}$, the potential $V_{N1}$ falls due to the capacitive coupling of the line $\overline{WL}_0$ and the node $N_1$; however, the potential $V_{N1}$ immediately returns to $V_{ss}$ due to the on-state transistor $Q_m$, as illustrated in Fig. 7B. In this case, a small quantity of charges are stored in the capacitor $C_m$. After that, during the rising of the potential $V_{\overline{WL}}$, the potential $V_{N1}$ rises also due to capacitive coupling; however, also in this case, the potential $V_{N1}$ returns to $V_{ss}$. When $V_{N1}$ has returned to $V_{ss}$ the potential of $V_{\overline{WL}}$ is $V_{cc}$. Thus, the capacitor $C_m$ stores charges $-V_{cc} \cdot C_m$. Thus, the refresh operation for the data "0" is completed.

It should be noted that, in the above-mentioned operation, the transistor $Q_m$ is always conductive, since the difference in potential between the gate and the source (or drain) is larger than the threshold voltage $V_{th}$ of the transistor $Q_m$.

Contrary to the above, if the data stored in the cell $C_{00}$ is "1", that is, the potential $V_{N1}$ at the node $N_1$ is higher than $V_{cc}-V_{th}-a$, a current flows from the node $N_1$ to the bit line $BL_0$ when the potential $V_{WL}$ of the word line $WL_0$ is $V_{cc}$. As a result, the potential $V_{BL}$ of the bit line $BL_0$ rises, while, the potential $V_{BL}$ of the bit line $\overline{BL}$ remains at the level $V_{cc}-V_{th}-a$. In this case, the difference in potential between the bit lines $BL_0$ and $\overline{BL}_0$ is defined as $\Delta V_{BL}$, as illustrated in Fig. 7C. At the time $t_2$, the difference $\Delta V_{BL}$ is amplified so that the potential $V_{BL}$ of the bit line $BL_0$ reaches $V_{cc}$ and the potential $V_{\overline{BL}}$ of the bit line $\overline{BL}_0$ reaches $V_{ss}$. In this case, the potential $V_{N1}$ at the node $N_1$ is $V_{cc}-V_{th}$.

As illustrated in Fig. 7A, at the time $t_3$ when the potential $V_{\overline{WL}}$ of the power supply line $\overline{WL}_0$ is changed from $V_{cc}$ to $V_{ss}$, the potential $V_{N1}$ at the node $N_1$ falls due to the capacitive coupling, as illustrated in Fig. 7C, so that a current flows from the bit line $BL_0$ into the node $N_1$. As a result, a quantity of charges is stored in the capacitor C. Next, at the time $t_4$ when the potential $V_{\overline{WL}}$ is changed from $V_{ss}$ to $V_{cc}$, the potential $V_{N1}$ at the node $N_1$ rises so that the charges stored in the capacitor $C_m$ are going to flow out; however, in this state, the charges never flow out. This is because, at this time the potential $V_{WL}$ applied to the gate of the transistor $Q_m$ and the potential $V_{BL}$ applied to the drain of transistor $Q_m$ are both $V_{cc}$, so that the transistor $Q_m$ is non-conductive. Therefore, when the potential $V_{\overline{WL}}$ of the power supply line $\overline{WL}_0$ is changed from $V_{ss}$ to $V_{cc}$, a value $V_{cc}$ is added to the potential $V_{N1}$ at the node $N_1$ so that this potential $V_{N1}$ becomes $2V_{cc}-V_{th}$. This is a so-called bootstrap effect. After the read operation and the refresh operation for the data "1" are completed the potential of $V_{\overline{WL}}$ is $V_{cc}$, so the charge $(V_{cc}-V_{th})\times C$ is stored in the capacitor $C_m$.

Therefore, prior to the read operation for the data "1", the potential $V_{N1}$ at the node $N_1$ is $2V_{cc}-V_{th}$, as illustrated in Fig. 7C. In this state, again at the time $t_1$ when the potential $V_{WL}$ of the word line $WL_0$ is changed from $V_{ss}$ to $V_{cc}$, a current flows from the node $N_1$ into the bit line $BL_0$, so that the potential $V_{N1}$ at the node $N_1$ is decreased and in turn, the potential $V_{BL}$ of the bit line $BL_0$ is increased. In this case, the voltage-increased $\Delta V_{BL}$ of the potential $V_{BL}$ is

$$\Delta V_{BL}=\frac{C}{C+C_B}\{(2V_{cc}-V_{th})-(V_{cc}-V_{th}-a)\}$$

$$=\frac{C}{C+C_B}(V_{cc}+a).$$

On the other hand, the potential $V_{\overline{BL}}$ of the bit line $BL_0$ remains at the same level $V_{cc}-V_{th}-a$, since there is not dummy cell.

Thus, in the circuit of Fig. 6, the differences in potential between the bit lines $BL_0$ and $\overline{BL}_0$, prior to the operation of the sense amplifier $SA_0$, are

$$\frac{C}{C+C_B}(V_{cc}-V_{th}-a) \quad \text{and} \quad \frac{C}{C+C_B}(V_{cc}+a)$$

from the data "0" and "1", respectively. As compared with the conventional circuit of Fig. 3 in which such a difference is

$$\frac{1}{2}\times\frac{C}{C_B}(V_{cc}-V_{th}),$$

an increase of the difference in potential between the bit lines $BL_0$ and $\overline{BL}_0$ is obtained, which means that the stored charges in the capacitor $C_m$ are helpful in the read operation.

In the above-mentioned embodiment, the difference in potential between the bit lines $BL_0$ and $\overline{BL}_0$ for the data "0" is different from the difference for the data "1"; however, the two differences can be equal by providing an appropriate dummy memory cell.

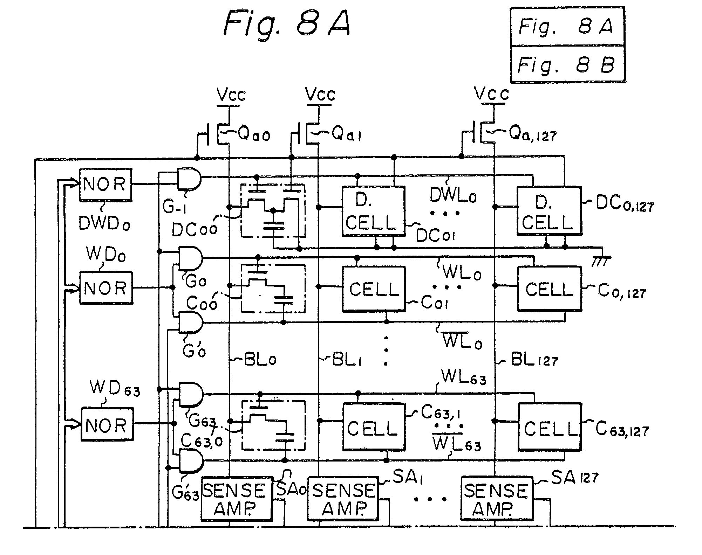

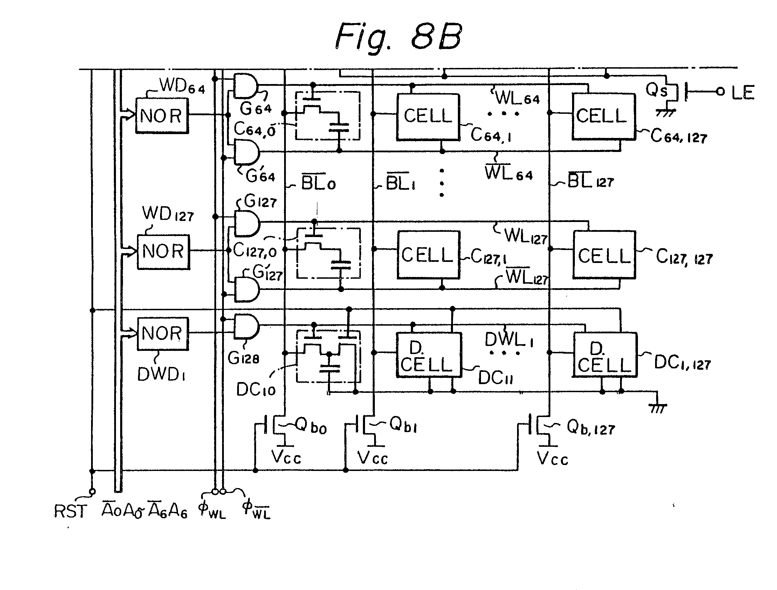

Fig. 8 is a block diagram illustrating another embodiment of the semiconductor memory device according to the present invention. In Fig.

8, the elements which are the same as those of Fig. 5 are denoted by the same references. In Fig. 8, dummy memory cells $DC_{00}$, $DC_{01}$, ..., $DC_{0,127}$; $DC_{10}$, $DC_{11}$, ..., $DC_{1,127}$ are provided in addition to the memory cells in Fig. 5. In this case, the capacitance of a capacitor of the dummy memory cells is the same as that of the memory cells.

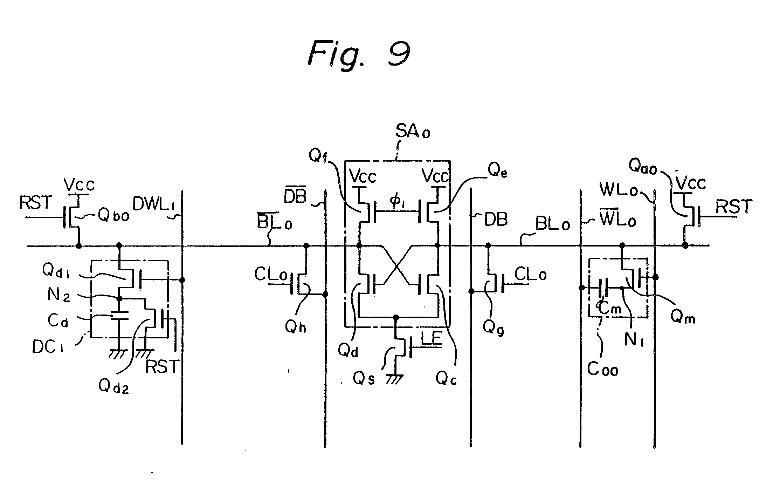

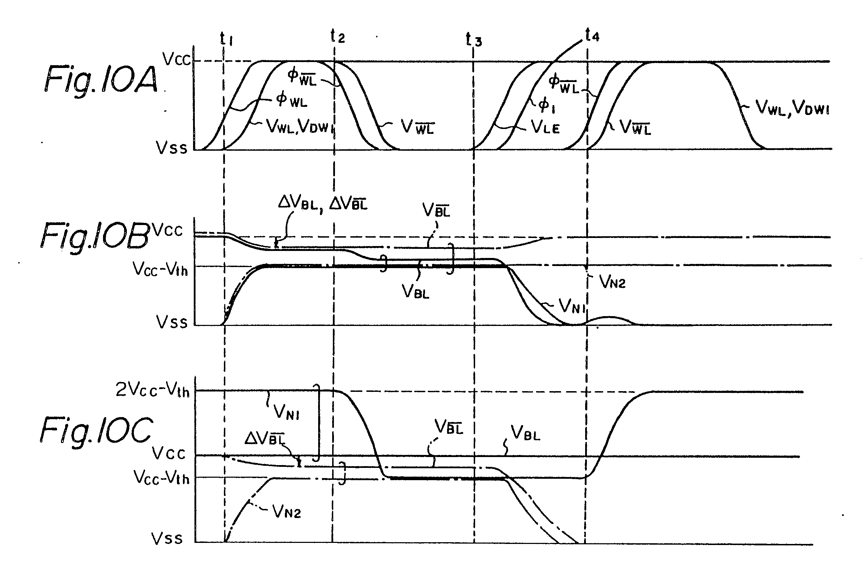

The operation of the device of Fig. 8 will be explained by using Fig. 9 and Figs. 10A, 10B and 10C. Here, Fig. 9 is a circuit diagram of a part of the device of Fig. 8 and Figs. 10A, 10B and 10C are timing diagrams of the signals appearing in the circuit of Fig. 9. In more detail, Figs. 10B and 10C are used for explaining the read operation for the data "0" and "1" respectively.

In the stand-by state, the bit lines $BL_0$ and $\overline{BL_0}$ are precharged to $V_{cc}$. In order to read the data "0", at the time $t_1$ when the potentials $V_{WL}$ and $V_{DW1}$ are changed from $V_{ss}$ to $V_{cc}$, the potentials $V_{BL}$ and $V_{\overline{BL}}$ of the bit lines $BL_0$ and $\overline{BL_0}$ are both decreased from $V_{cc}$ to $V_{cc}-\Delta V_{BL}(=\Delta V_{\overline{BL}})$, as illustrated in Fig. 10B. The voltage-drop $\Delta V_{BL}(=\Delta V_{\overline{BL}})$ is, in this case,

$$\Delta V_{BL}=\Delta V_{\overline{BL}}=\frac{C}{C_B}(V_{cc}-V_{th})$$

After that, at the time $t_2$ when the potential $V_{\overline{WL}}$ of the power supply line $\overline{WL_0}$ is changed from $V_{cc}$ to $V_{ss}$, a current flows from the bit line $BL_0$ to the node $N_1$ of the cell $C_{00}$, so that the potential $V_{BL}$ of the bit line $BL_0$ is further decreased by

$$\frac{C}{C_B}V_{cc}.$$

As a result, the difference in potential between the bit lines $BL_0$ and $\overline{BL_0}$ is

$$\frac{C}{C_B}V_{cc}.$$

On the other hand, if the data stored in the cell $C_{00}$ is "1", at the time $t_1$, a current flows from the bit line $\overline{BL_0}$ to the node $N_2$ so that the potential $V_{N2}$ at the node $N_2$ rises from $V_{ss}$ to $V_{cc}-V_{th}$ and in turn, the potental $V_{\overline{BL}}$ of the bit line $\overline{BL_0}$ falls, as illustrated in Fig. 10C. In this case, the voltage-drop $\Delta V_{\overline{BL}}$ is

$$\Delta V_{\overline{BL}}=\frac{C}{C_B}(V_{cc}-V_{th}).$$

On the other hand, in the memory cell $C_{00}$, the transistor $Q_m$ remains non-conductive so that the potential $V_{BL}$ of the bit line $BL_0$ remains at the level $V_{cc}$. Next, at the time $t_2$, the falling of the potential $V_{\overline{WL}}$ of the power supply line $\overline{WL_0}$ causes the potential $V_{N1}$ at the node $N_1$, to also be decreased; however, even in this case, the transistor $Q_m$ remains non-conductive so that the potential $V_{BL}$ of the bit line BL remains at the level $V_{cc}$.

Therefore the difference in potential between the bit lines $\overline{BL_0}$ and $BL_0$ is

$$\frac{C}{C_B}(V_{cc}-V_{th}).$$

After such a difference in potential between the bit lines $BL_0$ and $\overline{BL_0}$ is generated, at the time $t_3$, the sense amplifier $SA_0$ is operated. As a result, as illustrated in Figs. 10B and 10C, one of the potentials $V_{BL}$ and $V_{\overline{BL}}$ reaches $V_{ss}$ and the other reaches $V_{cc}$. Further, at the time $t_4$ when the potential $V_{\overline{WL}}$ is changed from $V_{ss}$ to $V_{cc}$, the potential $V_{N1}$ at the node $N_1$ returns to $V_{ss}$ or $2V_{cc}-V_{th}$ responsive to the data "0" or "1", as illustrated in Fig. 10B or 10C.

In the embodiment as illustrated in Figs. 8, 9, 10A, 10B and 10C, the falling of the potential $V_{\overline{WL}}$ of the power supply line $\overline{WL_0}$ follows the rising of the potential $V_{\overline{WL}}$ of the word line $WL_0$; however, the falling of the potential $V_{WL}$ can be effected simultaneously with the rising of the potential $V_{WL}$, which causes no problem. In addition, the two differences in potential between the bit lines $BL_0$ and $\overline{BL_0}$ for the data "0" and "1" can be the same as each other by selecting the capacitance of the capacitor $C_d$.

As explained hereinbefore, the present invention has an advantage, over the conventional device, in that the read operation is stable. This is because an increase is provided for the difference in potentials between a pair of bit lines prior to the operation of the sense amplifiers.

**Claims**

1. A semiconductor memory device comprising:
   a plurality of word lines ($WL_0$ to $WL_{127}$;
   a plurality of power supply lines ($\overline{WL_0}$ to $\overline{WL_{127}}$);
   a plurality of pairs of bit lines ($BL_0$, $\overline{BL_0}$ to $BL_{127}$, $\overline{BL_{127}}$);
   a plurality of sense amplifiers ($SA_0$ to $SA_{127}$), each arranged between the bit lines of one of said pairs of bit lines ($BL_0$, $\overline{BL_0}$ to $BL_{127}$, $\overline{BL_{127}}$);
   a plurality of memory cells ($C_{00}$ to $C_{127,127}$), each comprising a transistor ($Qm$) and a capacitor ($Cm$), said transistor ($Qm$) having a gate connected to one of said word lines and a drain connected to one of said bit lines, said capacitor ($Cm$) having an electrode ($P_1$, $N_1$) connected to a source of said transistor ($Qm$) and a counter electrode ($P_2$) connected to one of said power supply lines; and
   a plurality of means ($G'_0$ and $G'_{127}$), each connected to one of said power supply lines ($\overline{WL_0}$ to $\overline{WL_{127}}$) for supplying a signal ($\phi_{\overline{WL}}$) to the power supply line;
   characterised in that
   when one of said plurality of word lines ($WL_0$ to $WL_{127}$) is selected, for reading a memory cell the gate of the transistor ($Qm$) of which is connected to that one word line, that one of said plurality of means ($G'_0$ to $G'_{127}$) connected to that one of the said plurality of power supply lines ($\overline{WL_0}$ to $\overline{WL_{127}}$) which is connected to the counter electrode of the capacitor (Cm) of the memory cell concerned is selectively operable, during an active memory cycle, at the time of or after the rising of the potential of the selected word line, to supply to the said one power supply line a clock signal ($\phi_{\overline{WL}}$) which falls and after that rises.

2. A device as claimed in claim 1, wherein the potential of said clock signal ($\phi_{\overline{WL}}$) falls from a first power supply potential ($V_{CC}$) to a second power supply potential ($V_{SS}$) and, after that, rises from the second power supply potential ($V_{SS}$) to the first power supply potential ($V_{CC}$).

3. A device as claimed in claim 2, further comprising:
two dummy word lines (DWL$_0$, DWL$_1$); and a plurality of dummy memory cells (DC$_{00}$ to DC$_{0,127}$, DC$_{10}$ to DC$_{1,127}$), each connected to one of said bit lines (BL$_0$ to BL$_{127}$, $\overline{BL_0}$ to $\overline{BL_{127}}$), one of said dummy word lines and to receive the second power supply potential ($V_{SS}$).

4. A device as claimed in claim 3, wherein each of said dummy memory cells comprises
a first dummy transistor (Qd1) having a drain connected to one of said bit lines, a gate connected to one of said dummy word lines;
a dummy capacitor (Cd) having an electrode connected to a source of said first dummy transistor (Qd1) and a counter electrode connected to receive said second power supply potential ($V_{SS}$); and
a second dummy transistor (Qd2) having a drain and a source connected to said electrode and said counter electrode of said dummy capacitor, respectively, and a gate for receiving a reset signal (RST).

5. A device as claimed in claim 4, wherein the capacitance of the dummy capacitor (Cd) of a dummy memory cell is the same as that of the capacitor (Cm) of a memory cell.

**Patentansprüche**

1. Halbleiterspeichervorrichtung mit:
einer Vielzahl von -Wortleitungen (WL$_0$ bis WL$_{127}$);
einer Vielzahl von Energieversorgungs-leitungen ($\overline{WL_0}$ bis $\overline{WL_{127}}$);
einer Vielzahl von Paaren von Bitleitungen (BL$_0$, $\overline{BL_0}$ bis BL$_{127}$, $\overline{BL_{127}}$);
einer Vielzahl von Leseverstärken (SA$_0$ bis SA$_{127}$), die jeweils zwischen den Bitleitungen von einem der genannten Paare von Bitleitungen (BL$_0$, $\overline{BL_0}$ bis BL$_{127}$, $\overline{BL_{127}}$) angeordnet sind;
einer Vielzahl von Speicherzellen (C$_{00}$ bis C$_{127,127}$), die jeweils einen Transistor (Qm) und einen Kondensator (Cm) umfassen, von denen der Transistor (Qm) ein Gate hat, das mit einer der genannten Wertleitungen verbunden ist, und ein Drain, das mit einer der genannten Bitleitungen verbunden ist, während der Kondensator (Cm) eine Elektrode (P$_1$, N$_1$) hat, die mit einer Source des genannten Transistors (Qm) verbunden ist, und eine Gegenelektrode (P$_2$), die mit einer der

genannten Energievorsorgungsleitungen verbunden ist; und
einer Vielzahl von Einrichtungen (G'$_0$ bis G'$_{127}$), die jede mit einer der genannten Energieversor-gungsleitungen ($\overline{WL_0}$ bis $\overline{WL_{127}}$) zur Zuführung eines Signals ($\phi_{\overline{WL127}}$) zu der Energieversorgungs-leitung verbunden sind;
dadurch gekennzeichnet, daß
dann, wenn eine der genannten Vielzahl von Wortleitungen (WL$_0$ bis WL$_{127}$) ausgewählt wird, um eine Speicherzelle zu lesen, von der das Gate des Transistors (Qm) mit der einen Wortleitung verbunden ist, diejenige der Vielzahl von Einrich-tungen (G'$_0$ bis G'$_{127}$), die mit der einen der genannten Vielzahl von Energieversorgungs-leitungen ($\overline{WL_0}$ bis $\overline{WL_{127}}$), die mit der Gegen-elektrode des Kondensators (Cm) der betreffenden Speicherzelle verbunden ist, selektiv betreibbar ist, während eines aktiven Speicherzyklus, zur Zeit des oder nach dem Anstieg des Potentials der ausgewählten Wortleitung, um der genannten einen Energieversorgungsleitung ein Taktsignal ($\phi_{\overline{WL}}$) zu liefern, welches abfällt und danach ansteigt.

2. Vorrichtung nach Anspruch 1, bie welcher das Potential des genannten Taktsignals ($\phi_{\overline{WL}}$) von einem ersten Energieversorgungspotential ($V_{CC}$) auf ein zweites Energieversorgungs-potential ($V_{SS}$) abfällt und danach von dem zweiten Energieversorgungspotential ($V_{SS}$) zu dem ersten Energieversorgungspotential ($V_{cc}$) ansteigt.

3. Vorrichtung nach Anspruch 2, ferner mit zwei blinden Wortleitungen (DWL$_0$, DWL$_1$); und einer Vielzahl von blinden Speicherzellen (DC$_{00}$ bis DC$_{0,127}$, DC$_{10}$ bis DC$_{1,127}$), von denen jede mit einer der genannten Bitleitungen (BL$_0$ bis BL$_{127}$, $\overline{BL_0}$ bis $\overline{BL_{127}}$), mit einer der genannten blinden Wortleitungen, und zum Empfang des zweiten Energieversorgungspotentials ($V_{SS}$) angesch-lossen ist.

4. Vorrichtung nach Anspruch 3, bei welcher jede der genannten blinden Zellen umfaßt
einen ersten blinden Transistor (Qd1), der ein Drain hat, das mit einer der genannten Bitleitungen verbunden ist, und eine Gate, das mit einer der genannten blinden Wortleitungen verbunden ist;
einen Blindkondensator (Cd), der eine Elektrode hat, die mit einer Source des ersten blinden Transistors (Qd1) verbunden ist, und eine Gegenelektrode, die zum Empfang des genannten zweiten Energieversorgungspotentials ($V_{SS}$) ver-bunden ist; und
einen zweiten blinden Transistor (Qd2), der ein Drain und eine Source hat, die mit der genannten Elektrode bzw. der genannten Gegenelektrode des blinden Kondensators verbunden sind, und ein Gate zum Empfang eines Rückstellsignals (RST).

5. Vorrichtung nach Anspruch 4, bei welcher die Kapazität des blinden Kondensators (Cd) einer blinden Speicherzelle dieselbe ist wie diejenige des Kondensators (Cm) von einer Speicherzelle.

## Revendications

1. Dispositif de mémoire à semi-conducteurs, comprenant:

plusieurs lignes de mots ($WL_0$ à $WL_{127}$),

plusieurs lignes d'alimentation ($\overline{WL_0}$ à $\overline{WL_{127}}$),

plusieurs paires de lignes de bits ($BL_0$, $\overline{BL_0}$ à $BL_{127}$, $\overline{BL_{127}}$),

plusieurs amplificateurs de lecture ($SA_0$ à $SA_{127}$) disposés chacun entre les lignes de bits de l'une desdites paires des lignes de bits ($BL_0$, $\overline{BL_0}$ à $BL_{127}$, $\overline{BL_{127}}$),

plusieurs cellules de mémoire ($C_{00}$ à $C_{127,127}$) comportant chacune un transistor ($Qm$) et un condensateur ($Cm$), ledit transistor ($Qm$) comprenant une grille connectée à l'une desdites lignes de mots et un drain connecté à l'une desdites lignes de bits, ledit condensateur ($Cm$) comportant une électrode ($P_1$, $N_1$) connectée à une source dudit transistor ($Qm$) et une contre-électrode ($P_2$) connectée à l'une desdites lignes d'alimentation, et

plusieurs dispositifs ($G'_0$ à $G'_{127}$), connectés chacun à l'une des lignes d'alimentation ($\overline{WL_0}$ à $\overline{WL_{127}}$) pour appliquer un signal ($\phi_{\overline{WL}}$) à la ligne d'alimentation,

caractérisé en ce que

lorsque l'une desdites plusieurs lignes de mots ($WL_0$ à $WL_{127}$) est sélectionnée pour lire une cellule de mémoire qui, par la grille du transistor ($Qm$), est connectée à cette ligne de mots, celui desdits plusieurs dispositifs ($G'_0$ à $G'_{127}$) connectés à celle desdites plusieurs lignes d'alimentation ($\overline{WL_0}$ à $\overline{WL_{127}}$) qui est connectée à la contre-électrode du condensateur ($Cm$) de la cellule de mémoire concernée est commandé sélectivement pendant un cycle de mémoire actif au moment de, ou après, l'augmentation du potentiel de la ligne de mots sélectionnée, pour fournir à ladite ligne d'alimentation un signal d'horloge ($\phi_{\overline{WL}}$) qui décroît et qui augmente ensuite.

2. Dispositif selon la revendication 1, dans lequel le potentiel dudit signal d'horloge ($\phi_{\overline{WL}}$) décroît dequis un premier potentiel d'alimentation ($V_{CC}$) jusqu'à un second potentiel d'alimentation ($V_{SS}$) et, ensuite, augmente du second potentiel d'alimentation ($V_{SS}$) jusqu'au premier potentiel d'alimentation ($V_{CC}$).

3. Dispositif selon la revendication 2, comportant en outre:

deux fausses lignes de mots ($DWL_0$, $DWL_1$), et plusieurs fausses cellules de mémoire ($DC_{00}$ à $DC_{0,127}$, $DC_{10}$ à $DC_{1,127}$) connectées chacune à l'une desdites lignes de bits ($BL_0$ à $BL_{127}$, $\overline{BL_0}$ à $\overline{BL_{127}}$), à l'une desdites fausses lignes de mots et pour recevoir le second potentiel d'alimentation ($V_{SS}$).

4. Dispositif selon la revendication 3, dans lequel chacune desdites fausses cellules de mémoire comporte:

un premier faux transistor ($Qd1$) dont le drain est connecté à l'une desdites lignes de bits, dont la grille est connectée à l'une desdites fausses lignes de mots;

un faux condensateur ($Cd$) comprenant une électrode connectée à une source dudit premier faux transistor ($Qd1$) et une contre-électrode connectée pour recevoir ledit second potentiel d'alimentation ($V_{SS}$) et

un second faux transistor ($Qd2$) comprenant un drain et une source connectés respectivement à ladite électrode et à ladite contre-électrode dudit faux condensateur, et une grille pour recevoir un signal de mise à zéro ($RST$).

5. Dispositif selon la revendication 4, dans lequel la capacité du faux condensateur ($Cd$) d'une fausse cellule de mémoire est la même que celle du condensateur ($Cm$) d'une cellule de mémoire.

## Fig. 1A

## Fig. 1B

# Fig. 2A

| Fig. 2 A |
|----------|
| Fig. 2 B |

Fig. 2B

0 037 262

3

Fig. 3

Fig. 4A

Fig. 4B

Fig. 4C

5

# Fig. 5A

0 037 262

*Fig. 5 B*

7

Fig. 6

Fig. 7A

Fig. 7B

Fig. 7C

# Fig. 8 A

| Fig. 8 A |
|----------|
| Fig. 8 B |

Fig. 8B

Fig. 9

Fig.10A

$V_{cc}$

$\phi_{\overline{WL}}$
$\phi_{WL}$
$V_{WL}, V_{DW1}$

$V_{\overline{WL}}$

$\phi_{WL}$
$\phi_1$
$V_{LE}$

$\phi_{\overline{WL}}$

$V_{WL}, V_{DW1}$

$V_{\overline{WL}}$

$V_{ss}$

$t_1$  $t_2$  $t_3$  $t_4$

Fig.10B

$V_{cc}$

$V_{cc}-V_{th}$

$\Delta V_{BL}, \Delta V_{\overline{BL}}$

$V_{\overline{BL}}$

$V_{BL}$

$V_{N2}$

$V_{N1}$

$V_{ss}$

Fig.10C

$2V_{cc}-V_{th}$

$V_{cc}$

$V_{cc}-V_{th}$

$V_{N1}$

$\Delta V_{\overline{BL}}$

$V_{N2}$

$V_{\overline{BL}}$

$V_{BL}$

$V_{ss}$